# EUROPEAN PATENT APPLICATION

(11) **EP 4 535 966 A1**
(43) Date of publication of application: **09.04.2025**
(21) Application number: 23816288.7
(22) Date of filing: 24.05.2023
(51) Int. Cl.: H10K 30/30, H10K 30/10, H01L 31/0687, H01L 31/05

(54) **TANDEM SOLAR CELL AND METHOD FOR MANUFACTURING SAME**

(30) Priority: 30.05.2022 KR 20220066153
(71) Applicant: Hanwha Solutions Corporation, Jung-gu Seoul 04541 (KR)
(72) Inventor: CHOI, In Young, Seoul 04541 (KR)
(74) Representative: Mooser, Sebastian Thomas
(86) International application number: PCT/KR2023/007114
(87) International publication number: WO 2023/234627

(57) **Abstract**

The present disclosure provides a tandem solar cell device and a manufacturing method thereof, which may secure the stability of the electrical/mechanical connection between the top cell and the bottom cell while sufficiently using the excellent characteristics of a tandem solar cell and enabling the omission of the recombination layer, maximize the process efficiency and economic feasibility due to the omission of an intermediate layer, and prevent optical losses such as reflection loss or parasitic absorption caused by the recombination layer, thereby significantly improving the photovoltaic efficiency.

## Description

### CROSS-REFERENCE TO RELATED APPLICATIONS

This application claims the priority of Korean Patent Application No. 10-2022-0066153 filed on 30 May 2022, in the Korean Intellectual Property Office, the disclosure of which is incorporated herein by reference.

### BACKGROUND

### Field

The present disclosure relates to a tandem solar cell, and more particularly, to a tandem solar cell and a manufacturing method thereof which do not require an additional layer for an electrical connection of a top cell and a bottom cell having different band gaps.

### Description of the Related Art

Multi-junction (tandem) solar cells are an attempt to minimize thermalization loss by effectively utilizing solar energy over a wide wavelength range by vertically stacking light absorbing layers with different band gaps. Specifically, the tandem solar cells can overcome efficiency limitations of single-junction solar cells by minimizing the loss of excess energy of electrons and holes generated when photons with energy higher than the band gap in a single-junction solar cell are absorbed by a light absorbing layer by having light absorbing layers with different band gaps that divide and absorb sunlight by wavelength range. As an interest in tandem solar cells as the most feasible next-generation solar cell has increased recently, fierce research and development competition to secure tandem solar cell technology of various structures is taking place worldwide.

However, in such a tandem type solar cell, there is a limit in commercialization due to the following problems.

First, in general, in the case of the tandem solar cells, a connection between top and bottom cells is very important due to characteristics of a heterojunction, but tandem solar cells reported to date have a problem in that they cannot satisfy both the stability of the electrical connection between the top and bottom cells and optical efficiency. That is, when manufacturing the tandem solar cell, the bottom cell must be protected from damage while processing the top cell, efficient charge recombination between the top and bottom cells must be possible to ensure good light transmission from a front cell to a rear cell, and high transparency must be achieved. However, tandem solar cells that fully utilize superior optical properties compared to single-junction solar cells while satisfying both electrical and mechanical stability have not been reported.

Second, as a part of an effort to overcome the above-described problem, a study was reported on forming a recombination layer between the top and bottom cells of the tandem solar cell. However, in this case, an upper process is limited depending on a surface texturing shape of the bottom cell, and there is a problem that photovoltaic efficiency is reduced due to electrical/optical losses caused by reflection loss and parasitic absorption of a solar cell device due to an additional layer in the middle.

Third, even if the recombination layer is developed to improve interface characteristics of tandem solar cells and enhance electrical/mechanical stability, expensive high-vacuum deposition equipment such as sputter and PECVD is required to form the recombination layer between the top and bottom cells, and the addition of a new layer that did not previously exist increases the process time and process cost, and there is a problem that the economic feasibility is significantly reduced due to the problem of incompatibility with existing equipment.

Accordingly, there is an urgent need for research on tandem solar cells that can maximize process efficiency by not requiring an additional layer for charge recombination between the top and bottom cells of the tandem solar cell, while ensuring the stability of the electrical/mechanical connection between the top and bottom cells, and significantly improving the efficiency of the tandem solar cell by enabling excellent light transmittance and efficient charge recombination without the formation of an additional layer.

### SUMMARY

The present disclosure is contrived to solve the above-described problem, and an object to be achieved by the present disclosure is to provide a tandem solar cell capable of ensuring the stability of an electrical/mechanical connection between a top cell and a bottom cell by not requiring an additional layer, such as a recombination layer for electrically connecting the top and bottom cells of a conventional tandem solar cell.

Further, an object of the present disclosure is to provide a tandem solar cell that can omit a recombination layer while fully utilizing excellent characteristics of the tandem solar cell, thereby maximizing process efficiency and economic feasibility, and can prevent optical losses such as reflection loss or parasitic absorption due to layers added in the middle, thereby significantly improving photovoltaic efficiency.

**In** order to solve the above-described object, the present disclosure provides a tandem solar cell device which includes: a silicon bottom cell; a perovskite top cell; and a multifunctional layer provided to be directly connected between the silicon bottom cell and the perovskite top cell.

Further, according to an embodiment of the present disclosure, the multifunctional layer is a p-type inorganic oxide such as NiOx, WOx, Vox, or CuOx.

In addition, the silicon bottom cell and the perovskite top cell are connected in series.

Further, the silicon bottom cell includes a p-type silicon layer and an n-type emitter layer disposed on the p-type silicon layer, and the n-type emitter layer performs charge recombination with the multifunctional layer at an upper portion of the silicon bottom cell.

In addition, the thickness of the multifunctional layer is 5 to 50 nm.

Further, the present disclosure provides a manufacturing method of the tandem solar cell device which includes: a first step of forming an emitter layer on an upper surface of a silicon bottom cell including a p-type silicon layer; a second step of forming a multifunctional layer on the emitter layer formed on the upper surface of the silicon bottom cell; and a third step is a step of forming a perovskite top cell on an upper surface of the multifunctional layer and connecting the silicon bottom cell and the perovskite top cell in series.

Further, according to an embodiment of the present disclosure, a doping concentration of an emitter for forming an emitter layer in the first step is 10 E¹⁹ cm⁻³ or more.

In addition, the second step is a step of forming the multifunctional layer by any one of electron beam deposition or sputtering.

Further, the third step is a step of forming the perovskite top cell on the multifunctional layer by any one of a solution process or sputtering.

Further, the present disclosure provides a solar cell module including the above-described solar cell device.

According to the present disclosure, the stability of the electrical/mechanical connection between the top cell and the bottom cell can be secured while sufficiently using the excellent characteristics of a tandem solar cell and enabling the omission of the recombination layer, the process efficiency and economic feasibility can be maximized due to the omission of an intermediate layer, and optical losses such as reflection loss or parasitic absorption caused by the recombination layer can be prevented, thereby significantly improving the photovoltaic efficiency.

The effects of the present disclosure are not limited to the aforementioned effects, and other effects, which are not mentioned above, will be apparently understood to a person having ordinary skill in the art from the following description.

The objects to be achieved by the present disclosure, the means for achieving the objects, and the effects of the present disclosure described above do not specify essential features of the claims, and, thus, the scope of the claims is not limited to the disclosure of the present disclosure.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a schematic diagram showing a tandem solar cell device according to an embodiment of the present disclosure;
FIG. 2 is a schematic diagram showing a tandem solar cell device according to another embodiment of the present disclosure;
FIGS. 3 and 4 are graphs showing photovoltaic efficiency according to embodiments of the present disclosure;
FIG. 5 shows an SEM image according to an embodiment of the present disclosure; and
FIG. 6 is a graph showing external quantum efficiency according to an Example and a Comparative Example of the present disclosure.

### DETAILED DESCRIPTION OF THE EMBODIMENT

The present disclosure will be described more fully hereinafter, in which embodiments of the invention are shown. The present disclosure may be implemented in various different forms and is not limited to embodiments described herein.

As described above, conventional tandem solar cells have limitations in commercialization due to problems such as decreased photovoltaic efficiency and decreased process efficiency caused by a recombination layer for electrically connecting top and bottom cells.

Accordingly, the present disclosure provides a tandem solar cell device including a silicon bottom cell, a multifunctional layer performing hole transport and charge recombination, and a perovskite top cell arranged so that the multifunctional layer and the silicon bottom cell are in contact, and a manufacturing method of the tandem solar cell device, which includes a first step of forming an emitter layer on an upper surface of a silicon bottom cell including a p-type silicon layer, a second step of forming a multifunctional layer on the emitter layer formed on an upper surface of the silicon bottom cell, and a third step of forming a perovskite top cell on an upper surface of the multifunctional layer to connect the silicon bottom cell and the perovskite top cell in series, to seek to solve the problems of the conventional tandem solar cell described above.

Through this, according to the present disclosure, the stability of the electrical/mechanical connection between the top cell and the bottom cell may be secured while sufficiently using the excellent characteristics of a tandem solar cell and enabling the omission of the recombination layer, the process efficiency and economic feasibility may be maximized due to the omission of an intermediate layer, and optical losses such as reflection loss or parasitic absorption caused by the recombination layer may be prevented, thereby significantly improving the photovoltaic efficiency.

In this specification, the bottom cell means a silicon solar cell formed on the bottom of the tandem solar cell, and the top cell means a perovskite solar cell formed on the top of the tandem solar cell.

In addition, a texture structure in this specification means a structure formed in the silicon solar cell, and means including not only a structure formed by texturing widely used in the silicon solar cell, but also a structure derived therefrom.

In addition, in the present specification, the silicon bottom cell means a solar cell including silicon as a light absorbing layer, and the perovskite top cell means a solar cell including a material having a perovskite structure as the light absorbing layer.

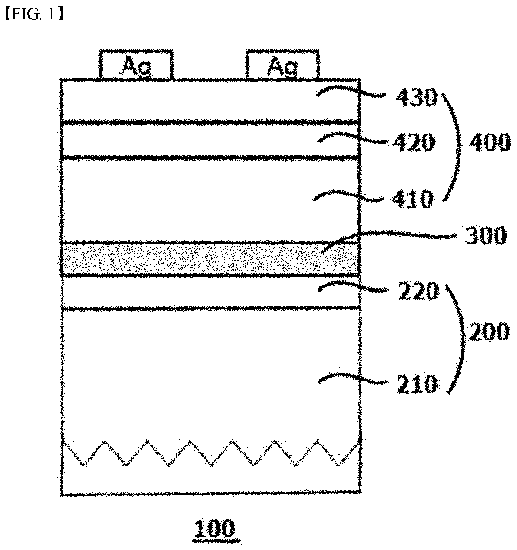

Hereinafter, a tandem solar cell device according to the present disclosure will be specifically described with reference to FIGS. 1 to 6.

A tandem solar cell device 100 according to the present disclosure includes a silicon bottom cell 200, a perovskite top cell 400, and a multifunctional layer 300 provided to be directly connected between the silicon bottom cell 200 and the perovskite top cell 400. That is, the tandem solar cell device 100 is implemented to include the silicon bottom cell 200 formed on the upper surface of a front electrode, the multifunctional layer 300 that performs hole transport and charge recombination, and the perovskite top cell 400 arranged so that the multifunctional layer 300 and the silicon bottom cell 200 are in contact.

The silicon bottom cell 200 includes a silicon layer 210, and an emitter layer 220 placed on the silicon layer 210, as shown in FIG. 1.

The silicon layer 210 may have one of the structures of a known silicon solar cell and is not limited to a specific structure. For example, the silicon layer 210 may include a crystalline silicon substrate (not shown), a p-type amorphous or crystalline silicon layer (not shown), an n-type amorphous or crystalline silicon layer (not shown), and an amorphous intrinsic silicon layer (not shown), and may further include additional layers as needed, although not shown in the drawing. According to a more preferred embodiment, the silicon layer 210 may be a p-type silicon layer and an n-type emitter layer 220 may be formed on top, considering industrial advantages of p-type silicon, such as ease of internal gettering that generally helps the improvement of cell efficiency compared to n-type silicon, or process simplification.

According to a preferred embodiment of the present disclosure, the structure of the silicon layer 210 is not particularly limited because the structure of the silicon layer 210 may be aluminum back surface field (Al-BSF), passivated emitter and rear cell (PERC), passivated emitter rear totally diffused (PERT), and passivated emitter and rear locally diffused (PERL) structure through formation of an n⁺⁺ emitter on the surface of the p-type silicon, or a tunnel oxide passivated contact (TOPCon) structure through formation of SiOx tunneling layer/n⁺⁺ poly-Si.

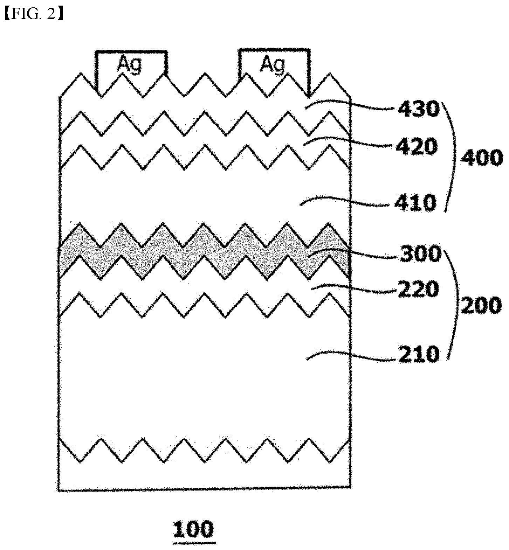

Meanwhile, at least a portion of one side or the other side of the silicon layer 210 may be textured to improve optical efficiency. That is, as shown in FIG. 2, a concave/convex surface is formed in a direction in which light is incident, and a light scattering effect of light incident through the concave/convex surface increases a path of light incident on the silicon layer 210, thereby improving light collection and thus increasing an absorption rate of sunlight.

The n-type emitter layer 220 may perform charge recombination with the multifunctional layer 300 on top of the silicon layer 210.

In the case of conventional general tandem solar cells, a recombination layer is provided as an intermediate layer to physically bond and electrically connect the silicon bottom cell and the perovskite top cell, thereby improving interface characteristics of the tandem solar cell and improving an electrical/mechanical stability.

The conventional recombination layer uses a conductive material having transparency, and for example, TCO-based materials such as indium tin oxide (ITO), indium cerium oxide (ICO), indium tungsten oxide (IWO), zinc indium tin oxide (ZITO), zinc indium oxide (ZIO), zinc tin oxide (ZTO), gallium Indium tin oxide (GITO), gallium indium oxide (GIO), gallium zinc oxide (GZO), aluminum doped zinc oxide (AZO), fluorine tin oxide (FTO), ZnO, etc. are used, or an nc-Si : H material layer is used to physically connect the top and bottom cells and electrically connect the top and bottom cells.

However, in the case of the tandem solar cells having the recombination layer of such a material, an upper process is limited depending on a surface texturing shape of the bottom cell, and there is thus a limit in improving the optical efficiency of an upper perovskite layer, and there is a problem in that photovoltaic efficiency is reduced due to electrical/optical losses caused by reflection loss and parasitic absorption of a solar cell device due to an additional layer in the middle.

Furthermore, in order to form the recombination layer between the top and bottom cells, expensive high-vacuum deposition equipment such as sputter and PECVD is required, and not only does the addition of a new layer increase the process time and process cost, but there is also a problem of greatly reduced economic feasibility due to the problem of incompatibility with existing equipment.

Accordingly, the present disclosure solves the above-described problem by enabling the n-type emitter layer 220 to perform charge recombination with the multifunctional layer 300 on top of the silicon layer 210.

That is, in the present disclosure, a transparent conductive oxide (TCO) material layer or an nc-Si : H material layer is not interposed between the multifunctional layer 300 and the silicon bottom cell 200 or between the multifunctional layer 300 and the perovskite top cell 400, and the silicon bottom cell and the perovskite top cell may be connected in series through the multifunctional layer 300.

More specifically, referring to FIGS. 1 and 2, the multifunctional layer 300 according to the present disclosure is interposed between an upper portion of the n-type emitter layer 220 and a lower portion of the perovskite top cell 400 to physically/electrically connect the silicon bottom cell 200 and the perovskite top cell 400 and perform charge recombination to electrically connect the silicon bottom cell 200 and the perovskite top cell 400 in series.

At this time, holes formed in the perovskite top cell 400 may move to the n-type emitter layer 220 through the multifunctional layer 300, and likewise, electrons formed in the silicon layer 210 may move to the multifunctional layer 300 through the n-type emitter layer 220 to perform recombination. In other words, the multifunctional layer 300 according to the present disclosure may play a role of the recombination layer that bonds the top and bottom cells in the conventional tandem solar cell.

To this end, a doping concentration of the n-type emitter layer 220 which is in contact with the multifunctional layer 300 may be controlled to 10 E¹⁹ cm⁻³ or more. Accordingly, a surface resistance of the n-type emitter layer 220 may be formed to be less than 100 ohm/sq. At this time, when the surface resistance of the n-type emitter layer 220 exceeds 100 ohm/sq, electrons formed in the silicon bottom cell may be restricted from moving upward, which may cause a decrease in efficiency.

In addition, the multifunctional layer 300 may have a thickness of 5 to 50 nm, and more preferably, may have a thickness of 5 to 20 nm. At this time, when the thickness of the multifunctional layer 300 is less than 5 nm, non-uniform electron movement may be caused due to non-uniform thin film formation or ineffective recombination may occur, and when the thickness of the multifunctional layer 300 exceeds 50 nm, a decrease in efficiency may be caused due to electrical loss due to insulation characteristics and optical loss due to increased parasitic absorption.

Meanwhile, the multifunctional layer 300 may be formed of any one selected from the group consisting of p-type inorganic oxides such as NiOx, WOx, Vox, and CuOx, and may preferably be formed of nickel oxide (NiOx). The above-described p-type inorganic oxide may have a vertical pillar shape by growing grains in a vertical direction during deposition, and in this case, the conductivity in a horizontal direction may be reduced, which may prevent the occurrence of a shunting effect due to a subsequent upper process and may be advantageous in securing the reproducibility of the device and in large-area production.

In addition, according to a preferred embodiment of the present disclosure, when the multifunctional layer 300 is formed of nickel oxide, the multifunctional layer 300 may perform a role of a hole transport layer (HTL). That is, when nickel oxide is formed as the multifunctional layer 300 as shown in FIGS. 1 and 2, the multifunctional layer 300 may serve as a recombination layer that bonds the silicon bottom cell 200 and the perovskite top cell 400 and, at the same time, serve as the hole transport layer (HTL) corresponding to an electron transport layer (ETL) included in the perovskite top cell 400. In this case, the nickel oxide formed in the vertical direction has good conductivity in the vertical direction and low conductivity in the horizontal direction, so that loss due to a shunting effect may be minimized in the tandem solar cell device 100 including the silicon bottom cell 200 and the perovskite top cell 400.

At this time, the composition of nickel oxide (NiOx) introduced into the multifunctional layer 300 may be controlled in a range of 0 < x < 3, and it is preferable to control the composition to 0 < x < 1 in consideration of a range of a target work function (4.5 <WF < 5.0) and a range of a valence band maximum (VMB) (0.3 < VBM < 1).

In addition, the multifunctional layer may have a thickness of 5 to 50 nm, and more preferably, may have a thickness of 5 to 20 nm. At this time, when the thickness of the multifunctional layer 200 is less than 5 nm, non-uniform electron movement may be caused due to non-uniform thin film formation or ineffective recombination may occur, and when the thickness of the multifunctional layer 200 exceeds 50 nm, a decrease in efficiency may be caused due to electrical loss due to insulation characteristics and optical loss due to increased parasitic absorption.

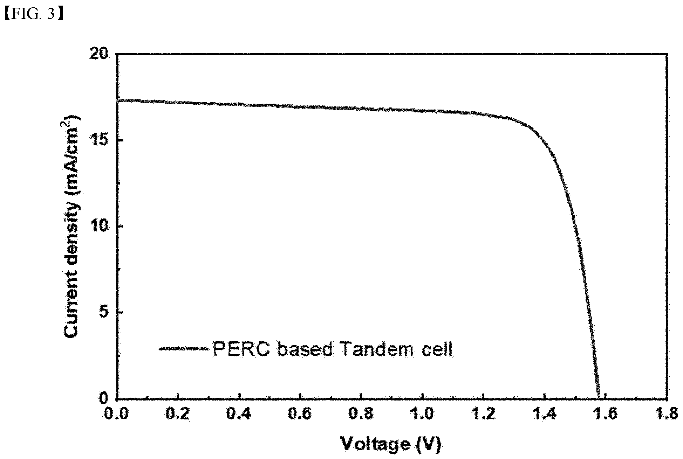

More specifically, referring to FIG. 3, in the case of a PERC-based tandem solar cell including the tandem solar cell device 100 according to the present disclosure, it can be seen that the silicon bottom cell 200 and the perovskite top cell 400 are connected in series to have a Voc of about 1.6 V and exhibit a photovoltaic efficiency of 21% or more.

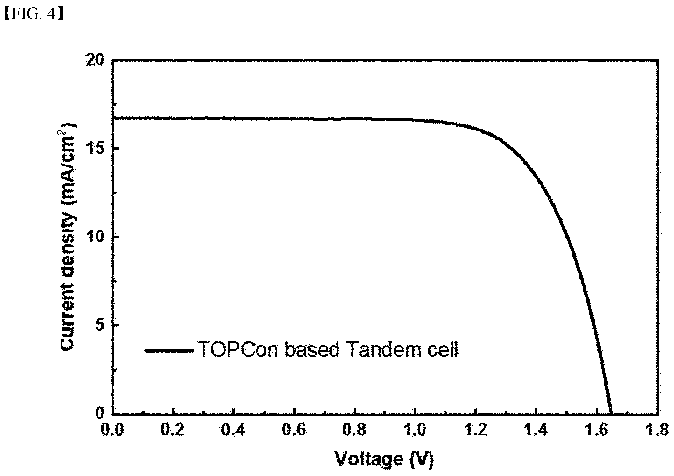

Further, referring to FIG. 4, in the case of a TOPCon-based tandem solar cell including the tandem solar cell device 100 according to the present disclosure, it can be seen that the silicon bottom cell 200 and the perovskite top cell 400 are connected in series to have a Voc of about 1.6 V and exhibit a photovoltaic efficiency of 20% or more.

Next, the perovskite top cell 400 is a top cell which is in contact with the silicon bottom cell 200, and a perovskite absorption layer 410, an electron transport layer 420, and a transparent conductive oxide electrode layer 430 may be sequentially stacked on the upper portion of the above-described multifunctional layer 300.

When the multifunctional layer 300 performs the role of the hole transport layer according to the preferred embodiment of the present disclosure as described above, it is impossible to implement the tandem solar cell device in which electrons move to an upper portion and holes move to a lower portion to form energy. However, this is just an example when the multifunctional layer 300 performs the role of the hole transport layer, and when the multifunctional layer 300 performs the role of the electron transport layer, the electron transport layer 420 may be the hole transport layer, so the positions of the hole transport layer and the electron transport layer 420 may be exchanged as needed.

The perovskite absorption layer 410 may be formed so that hole-electron pairs generated by receiving light energy from the sun may be separated into electrons or holes. In an embodiment, electrons formed in the perovskite absorption layer 410 may be transported to the electron transport layer 420, and holes formed in the perovskite absorption layer 410 may be transported to the hole transport layer.

At this time, the perovskite absorption layer 410 may include an organic halide perovskite such as methyl ammonium iodide (MAI), formamidinium iodide (FAI), or a metal halide perovskite such as lead iodide (PbI₂), bromine iodide (PbBr), and lead chloride (PbCl₂). That is, the perovskite absorption layer 410 may be a multilayer stacked structure including at least one of the organic halide perovskite or the metal halide perovskite. More specifically, the perovskite absorption layer 410 may be represented by AMX₃, (where A represents a monovalent organic ammonium cation or metal cation; M represents a divalent metal cation; and X represents a halogen anion). Non-limiting examples thereof may include CH₃NH₃PbI₃, CH₃NH₃PbIₓCl₃₋ₓ, CH3NH₃PbIxBr₃₋ₓ, CH₃NH₃PbClₓBr₃₋ₓ, HC(NH₂)₂PbI₃, HC(NH2)₂PbIxCl₃₋ₓ, HC(NH2)2PbIxBr3-x, HC(NH₂)₂PbClₓBr₃₋ₓ, (CH₃NH₃)(HC(NH₂)₂)_{1-y}PbI₃, (CH₃NH₃)(HC(NH₂)₂)_{1-y}PbIₓCl₃₋ₓ, (CH₃NH₃)(HC(NH₂)₂)_{1-y}PbIₓBr₃₋ₓ, or (CH₃NH₃)(HC(NH₂)₂)_{1-y}PbClₓBr₃₋ₓ (0 = x and y = 1).

The electron transport layer 420 serves to separate and transport electrons formed in the perovskite absorption layer 410, and may be formed of a known, conventional material that is suitable for the purpose of the present disclosure. Non-limiting examples thereof may include Ti oxide, Zn oxide, In oxide, Sn oxide, W oxide, Nb oxide, Mo oxide, Mg oxide, Zr oxide, Sr oxide, Yr oxide, La oxide, V oxide, Al oxide, Y oxide, Sc oxide, Sm oxide, Ga oxide, In oxide, SrTi oxide, and the like.

As described above, according to the present disclosure, the stability of the electrical/mechanical connection between the top cell and the bottom cell may be secured while sufficiently using the excellent characteristics of a tandem solar cell and enabling the omission of the recombination layer due to the multifunction layer 300, the process efficiency and economic feasibility may be maximized due to the omission of an intermediate layer, and optical losses such as reflection loss or parasitic absorption caused by the recombination layer may be prevented, thereby significantly improving the photovoltaic efficiency.

Accordingly, the present disclosure provides a solar cell module including a solar cell device exhibiting the above-described excellent photovoltaic efficiency. At this time, the solar cell module may include electrodes, encapsulating materials, additional stacked structures, etc., in addition to the solar cell device, and there are no special restrictions on this.

Next, a manufacturing method of the tandem solar cell device is described.

However, to avoid duplication, explanation of the parts that have the same technical idea as the tandem solar cell device described above will be omitted.

The manufacturing method of the tandem solar cell device according to the present disclosure includes a first step of forming an emitter layer on an upper surface of a silicon bottom cell including a p-type silicon layer, a second step of forming a multifunctional layer on the emitter layer formed on the upper surface of the silicon bottom cell, and a third step of forming a perovskite top cell on the upper surface of the multifunctional layer to connect the silicon bottom cell and the perovskite top cell in series.

The first step is the step of forming an n-type emitter layer on an upper surface of a silicon bottom cell including a p-type silicon layer.

That is, in the present disclosure, charge recombination with the multifunctional layer may be performed at an upper portion of the silicon layer through the first step. At this time, as the method for forming the n-type emitter layer, a known conventional method may be performed, and the method is not particularly limited thereto. However, in the first step, a doping concentration of an emitter for forming the emitter layer may be 10 E¹⁹ cm⁻³ or more, and more preferably, the emitter layer may be formed at a doping concentration of 10 E²⁰ cm⁻³ or more. In this case, it may be more advantageous in terms of efficient electron movement. However, when the emitter doping concentration is less than 10 E¹⁹ cm⁻³, there may be a problem of reduced recombination due to limited electron movement.

Further, forming an n-type emitter on the p-type silicon layer to induce recombination of charges may be particularly advantageous due to the above-described industrial advantages compared to the structure of forming a p-type emitter on an n-type silicon layer to induce recombination of charges.

Meanwhile, the introduction of the texture structure of the silicon bottom cell may adopt any one method of wet chemical etching, dry chemical etching, electrochemical etching, and mechanical etching, but is not particularly limited thereto, and a front electrode may be formed on a lower surface of the silicon bottom cell 200 through metal deposition or metal paste coating.

Next, the second step is a step of forming the multifunctional layer on the emitter layer formed on the upper surface of the silicon bottom cell.

In general, in the case of tandem solar cell devices connected in series through the recombination layer, in order to form the recombination layer between the top and bottom cells, expensive high-vacuum deposition equipment such as a sputter and PECVD is required, and not only does the addition of a new layer increase the process time and process cost, but there is also a problem of greatly reduced economic feasibility due to the problem of incompatibility with existing equipment.

Furthermore, the conventional method of forming the hole transport layer using a solution process has limitations in improving the optical efficiency of the upper perovskite layer because the upper process is limited depending on the surface texturing shape of the bottom cell by applying polymer materials such as PTAA and SAM.

Accordingly, the present disclosure solves the above-described problem by forming the multifunctional layer in the second step by either electron beam deposition or sputtering.

That is, according to the present disclosure, since the hole transport layer performs the role of the conventional recombination layer that electrically/physically connects the top and bottom cells, the upper processes are performed without adding the conventional recombination layer, which is advantageous in terms of process cost and speed. In addition, according to the preferred embodiment of the present disclosure, when the hole transport layer is implemented with NiOₓ, the hole transport layer may be formed by an electron beam evaporator, so that the process of the upper perovskite layer is possible without being limited by a surface shape of the lower silicon bottom cell, and thus it is possible to attempt to improve the optical efficiency of various shapes of upper perovskite layers.

At this time, the method of forming the multifunctional layer may use a conventional method as long as it is suitable for the purpose of the present disclosure, but preferably, thermal evaporation, solution spin coating, electron beam, or sputtering may be used, and most preferably, uniformly forming the multifunctional layer under high vacuum conditions using an electron beam or sputtering method may be advantageous in terms of reducing electrical resistance, forming a uniform thin film, and efficient charge transport in the vertical direction.

Next, the third step is a step of forming the perovskite top cell on the upper surface of the multifunctional layer and connecting the silicon bottom cell and the perovskite top cell in series.

The perovskite top cell is a top cell in contact with the silicon bottom cell, and the perovskite absorption layer, the electron transport layer, and the transparent conductive oxide electrode layer may be sequentially stacked on the upper portion of the multifunctional layer according to a known conventional method. More preferably, the third step may be advantageous in terms of forming a uniform thin film by forming the perovskite top cell on the multifunctional layer by either the solution process or sputtering.

Although the manufacturing method for the tandem solar cell device according to the present disclosure has been described above, this is only an example, and, excluding the layer that serves as the conventional recombination layer, an additional stacked structure capable of improving the photovoltaic efficiency may be further included.

Hereinafter, the present disclosure will be described more specifically through examples, but the following examples do not limit the scope of the present disclosure, and should be interpreted as helping to understand the present disclosure.

### Example 1 - Manufacturing of tandem solar cell device

A lower solar cell used a PERC structure cell that formed an n++ emitter layer through a POCl process on a p-type impurity-doped silicon substrate on which a lower passivation layer and a lower electrode are formed, manufactured by Hanwha Q CELLS. Next, an indium tin oxide (ITO) layer was formed with a thickness of 50 nm as a recombination layer at an upper portion of an n++ emitter layer using a sputtering device.

Afterwards, NiOx was deposited on the emitter layer using an E-beam deposition method under high vacuum conditions to form a 30 nm multifunctional layer. Next, the perovskite layer was formed with a thickness of 500 nm by spin-coating a solution of CsMAFAPbIxB3-x dissolved in dimethylformamide (DMF) and dimethyl sulfoxide (DMSO), and heat-treating on a hot plate at 100°C for minutes.

Next, an LiF thin film of <1 nm and a C60 thin film of 20 nm were deposited through a vacuum thermal evaporator and an SnOx of 6 nm thickness was deposited through atomic layer deposition (ALD), on the hole transport layer.

Next, indium doped zinc oxide (IZO) as the transparent electrode layer was formed with a thickness of 100 nm on the upper portion of the electron transport layer using a sputtering device.

Next, a PERC-based tandem solar cell device was manufactured by forming silver (Ag) with a thickness of 200 nm on top of the transparent electrode layer using a thermal evaporator under high vacuum conditions.

### Example 2 - Manufacturing of tandem solar cell device

Except that a TOPCon-based solar cell device of the silicon bottom cell was manufactured as shown in FIG. 2, the tandem solar cell device was manufactured similarly to Example 1 above. At this time, a cell with a TOPCon structure is a structure in which SiOx is formed as a passivation layer at an upper portion of a p-type impurity-doped silicon substrate on which a lower passivation layer and a lower electrode which are being manufactured by Hanwha Q CELLS are formed, and then an n+ doped poly-Si layer is formed.

### Comparative Example 1 - Manufacturing of tandem solar cell device

A typical tandem solar cell device was prepared containing an ITO thin film deposited by sputtering as a recombination layer, as in related art.

### Experimental Example 1 -Photovoltaic efficiency evaluation

The photovoltaic efficiency of the tandem solar cell devices according to Examples 1 and 2 above was measured under AM1.5G light conditions using solar simulator equipment, and the results are shown in FIGS. 3 and 4.

Referring to FIG. 3, it can be seen that Example 1 has a Voc of about 1.6 V and exhibits photovoltaic efficiency of 21% or more.

Further, referring to FIG. 4, it can be seen that Example 2 has a Voc of about 1.6 V and exhibits photovoltaic efficiency of 20% or more.

### Experimental Example 2 - SEM image

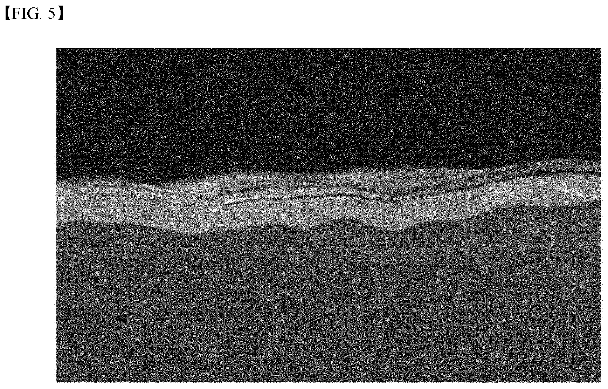

The SEM image of the tandem solar cell device according to Example 1 is shown in FIG. 5.

Referring to FIG. 5, it can be seen that in the case of Example 1, in which the tandem solar cell device was manufactured by forming NiOx formed directly on the silicon bottom cell using an E-beam and forming a perovskite upper layer, the perovskite upper layer was physically stably formed on the NiOx thin film.

### Experimental Example 3 - External quantum efficiency measurement

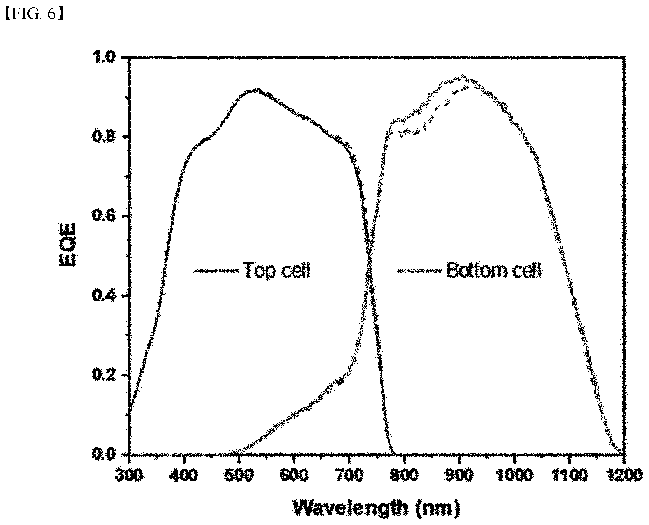

The external quantum efficiency of the tandem solar cell devices according to Example 1 and Comparative Example 1 was calculated and graphed through optical simulation, and is shown in FIG. 6.

Referring to FIG. 6, in the case of Comparative Example 1 including the conventional recombination layer like the related art, the low external quantum efficiency is provided like a dotted line graph, and a sum of top and lower currents is calculated as 37.93 mA/cm², while in the case of Example 1 according to the present disclosure, high external quantum efficiency is provided like a solid line graph, and the sum of the top and lower currents is calculated to have a higher current value than the related art as 38.38 mA/cm².

When the results are summarized, according to the present disclosure, the stability of the electrical/mechanical connection between the top cell and the bottom cell can be secured while sufficiently using the excellent characteristics of a tandem solar cell and enabling the omission of the recombination layer, the process efficiency and economic feasibility can be maximized due to the omission of an intermediate layer, and optical losses such as reflection loss or parasitic absorption caused by the recombination layer can be prevented, thereby significantly improving the photovoltaic efficiency.

## Claims

1. A tandem solar cell device comprising:
a silicon bottom cell;
a perovskite top cell; and
a multifunctional layer provided to be directly connected between the silicon bottom cell and the perovskite top cell.

2. The tandem solar cell device of claim 1, wherein the multifunctional layer is a p-type inorganic oxide such as NiOx, WOx, Vox, or CuOx.

3. The tandem solar cell device of claim 1, wherein the silicon bottom cell and the perovskite top cell are connected in series.

4. The tandem solar cell device of claim 1, wherein the silicon bottom cell includes a p-type silicon layer and an n-type emitter layer disposed on the p-type silicon layer, and
the n-type emitter layer performs charge recombination with the multifunctional layer at an upper portion of the silicon bottom cell.

5. The tandem solar cell device of claim 1, wherein a thickness of the multifunctional layer is 5 to 50 nm.

6. A manufacturing method of a tandem solar cell device comprising:
a first step of forming an emitter layer on an upper surface of a silicon bottom cell including a p-type silicon layer;
a second step of forming a multifunctional layer on the emitter layer formed on the upper surface of the silicon bottom cell; and
a third step of forming a perovskite top cell on an upper surface of the multifunctional layer and connecting the silicon bottom cell and the perovskite top cell in series.

7. The manufacturing method of a tandem solar cell device of claim 6, wherein a doping concentration of an emitter for forming the emitter layer in the first step is 10 E¹⁹ cm⁻³ or more.

8. The manufacturing method of a tandem solar cell device of claim 6, wherein the second step is a step of forming the multifunctional layer by any one of electron beam deposition or sputtering.

9. The manufacturing method of a tandem solar cell device of claim 6, wherein the third step is a step of forming the perovskite top cell on the multifunctional layer by any one of a solution process or sputtering.
